# FASCICULE DE BREVET EUROPEEN

(11) **EP 0 821 744 B1**
(45) Date de publication et mention de la délivrance du brevet: **04.08.1999**
(21) Numéro de dépôt: 96913599.5
(22) Date de dépôt: 17.04.1996
(51) Int. Cl.: C23C 16/04, C23C 16/44

(54) **PROCEDE D'INFILTRATION CHIMIQUE EN PHASE VAPEUR POUR LA DENSIFICATION DE SUBSTRATS POREUX DISPOSES EN PILES ANNULAIRES**
VERFAHREN ZUR CHEMISCHEN INFILTRATION IN DER GASPHASE, ZUR VERDICHTUNG PORÖSER ROTATIONSSYMMETRISCHER SUBSTRATSTAPELN
VAPOUR PHASE CHEMICAL INFILTRATION PROCESS FOR DENSIFYING POROUS SUBSTRATES DISPOSED IN ANNULAR STACKS

(30) Priorité: 18.04.1995 FR 9504586
(43) Date de publication de la demande: 04.02.1998
(73) Titulaire: SOCIETE NATIONALE D'ETUDE ET DE CONSTRUCTION DE MOTEURS D'AVIATION, "S.N.E.C.M.A.", 75015 Paris (FR)
(72) Inventeur: CHRISTIN, François, F-33160 Saint-Aubin-du-Medoc (FR); DAUBIGNY, Pierre, F-33160 Saint-Medard-en-Jalles (FR); DELAURENS, Pierre, F-33600 Pessac (FR); LELUAN, Jean-Luc, F-33200 Bordeaux (FR)
(74) Mandataire: Joly, Jean-Jacques
(86) Numéro de dépôt international: FR9600582
(87) Numéro de publication internationale: WO9633295

(56) Documents cités:
- EP-A- 0 393 520
- WO-A-87/04733
- US-A- 5 221 354
- PATENT ABSTRACTS OF JAPAN vol. 003, no. 046 (C-043), 18 Avril 1979 & JP,A,54 023039 (AGENCY OF IND SCIENCE & TECHNOL), 21 Février 1979,

## Description

La présente invention concerne un procédé d'infiltration chimique en phase vapeur pour la densification de substrats poreux disposés en piles annulaires, c'est-à-dire des substrats ayant sensiblement une forme de révolution avec un passage ou ouverture central qui sont disposés en au moins une pile délimitant un passage intérieur formé par les ouvertures centrales des substrats, ou des substrats ayant une forme non nécessairement annulaires mais qui sont disposés pour former une pile avec un passage intérieur délimité par les substrats empilés.

Le domaine d'application de l'invention est notamment la fabrication de pièces en matériau composite comprenant un substrat, ou préforme, poreux densifié par une matrice.

Pour la fabrication de pièces en matériau composite, en particulier de pièces en matériau composite thermostructural constituées d'une préforme fibreuse réfractaire (fibres carbone ou céramique, par exemple) densifiée par une matrice réfractaire (carbone ou céramique, par exemple), il est courant de faire appel à des procédés d'infiltration chimique en phase vapeur. Des exemples de telles pièces sont des tuyères de propulseurs en composite carbone-carbone (C-C), ou des disques de freins, notamment de freins d'avions, en composites C-C.

La densification de substrats poreux par infiltration chimique en phase vapeur consiste à placer les substrats dans une chambre de réaction d'une installation d'infiltration au moyen d'un outillage de support et à admettre dans la chambre une phase gazeuse dont un ou plusieurs constituants sont des précurseurs du matériau à déposer au sein des substrats afin d'assurer leur densification. Les conditions d'infiltration, notamment composition et débit de la phase gazeuse, et température et pression dans la chambre sont choisies pour permettre une diffusion de la phase gazeuse au sein de la porosité interne accessible des substrats afin qu'y soit déposé le matériau désiré par décomposition d'un constituant de la phase gazeuse ou réaction entre plusieurs constituants de celle-ci.

Les conditions d'infiltration chimique en phase vapeur du carbone pyrolytique, ou pyrocarbone, sont connues depuis longtemps de l'homme de l'art. Le précurseur du carbone est un alcane, un alkyle ou un alcène, généralement du propane, du méthane ou un mélange des deux. L'infiltration est réalisée à une température d'environ 1000°C sous une pression par exemple d'environ 1 kPa. Les conditions d'infiltration chimique en phase vapeur de matériaux autres que le carbone, notamment de matériaux céramiques, sont également bien connues. On pourra se référer en particulier au document FR-A-2 401 888.

Dans une installation industrielle d'infiltration chimique en phase vapeur, il est habituel de charger la chambre de réaction avec plusieurs substrats ou préformes à densifier simultanément, en utilisant un outillage de support comprenant notamment des plateaux et entretoises. Lorsque les préformes sont annulaires, elles peuvent être disposées en piles(s) dans une direction longitudinale de la chambre de réaction. La phase gazeuse contenant le ou les précurseurs du matériau à déposer au sein des préformes est admise à une extrémité longitudinale de la chambre tandis que les gaz résiduels sont évacués à l'extrémité opposée d'où ils sont extraits par des moyens de pompage. Des moyens sont généralement prévus pour préchauffer la phase gazeuse avant qu'elle atteigne les préformes à densifier, par exemple sous forme de plateaux de préchauffage perforés traversés par la phase gazeuse admise dans la chambre de réaction.

Une réelle difficulté rencontrée avec les procédés d'infiltration chimique en phase vapeur connus est d'assurer la constance de la microstructure du matériau déposé au sein des substrats. Dans le cas en particulier de pièces en matériau composite, il est nécessaire au regard des propriétés attendues de ces pièces que la microstructure de la matrice soit constante et conforme à celle désirée. Ainsi, dans l'exemple de l'infiltration de carbone pyrolytique, ou pyrocarbone, des variations même minimes des conditions d'infiltration peuvent conduire à des modifications de microstructure du pyrocarbone. Or, des pyrocarbones de types laminaire lisse, laminaire rugueux et isotrope ont des propriétés bien différentes. Si l'on cherche par exemple à obtenir une matrice pyrocarbone graphitable par traitement thermique, une microstructure de type laminaire rugueux doit de préférence être obtenue. En pratique, en dépit du soin apporté au contrôle des conditions d'infiltration, il a été constaté des modifications de la microstructure du pyrocarbone déposé au sein des préformes, en particulier celles les plus éloignées de l'accès de la phase gazeuse dans la chambre. Ces dérèglements de microstructure ont pu aller jusqu'à la formation de suies et à la formation de croissances arborescentes indésirables dans la chambre de réaction.

Pour résoudre ce problème, il a été essayé d'accroître sensiblement le débit de phase gazeuse admis dans la chambre, de sorte que la phase gazeuse se présente de façon similaire vis-à-vis des différentes préformes chargées. Mais il est alors nécessaire de prévoir un dispositif de pompage plus puissant, donc plus coûteux, et la consommation de phase gazeuse est plus importante. En outre, l'efficacité du préchauffage est diminuée si la phase gazeuse passe plus rapidement à travers les plateaux de préchauffage. Pour amener la phase gazeuse à la température voulue au plus tard à son premier contact avec une préforme à densifier, une augmentation du nombre de plateaux de préchauffage est nécessaire, mais alors au détriment du volume utile à l'intérieur de la chambre, donc du rendement global de l'installation.

Un objet de la présente invention est de fournir un procédé permettant d'éviter les inconvénients précités, c'est-à-dire un procédé d'infiltration chimique en phase vapeur permettant de garantir la constance de la microstructure déposée au sein de substrats densifiés, et ce sans requérir un accroissement du débit de phase gazeuse ou une limitation du volume de chargement préjudiciables en terme de coût et de rendement de l'installation.

Ce but est atteint grâce à un procédé d'infiltration chimique en phase vapeur pour densifier des substrats poreux par un matériau déposé au sein de ceux-ci, le procédé comprenant : le chargement des substrats à densifier à l'intérieur d'une chambre de réaction d'un four d'infiltration, les substrats étant disposés en au moins une pile annulaire ou creuse qui s'étend dans une direction longitudinale de la chambre et qui délimite un passage intérieur, avec des espaces ménagés entre des substrats ; l'admission, au voisinage d'une première extrémité longitudinale de la chambre de réaction, d'une phase gazeuse contenant au moins un précurseur du matériau à déposer ; et l'évacuation de gaz résiduels à travers une sortie située au voisinage de l'extrémité longitudinale de la chambre de réaction opposée à la première,

procédé selon lequel la phase gazeuse admise dans la chambre de réaction est canalisée vers l'un des deux volumes constitués par l'intérieur et l'extérieur de la ou des piles de substrats à son extrémité la plus proche de la première extrémité longitudinale de la chambre ; le volume dans lequel la phase gazeuse est canalisée est fermé à son extrémité la plus éloignée de la première extrémité longitudinale de la chambre ; et les espaces ménagés entre des substrats s'ouvrent à l'intérieur et à l'extérieur de la ou chaque pile de manière à équilibrer la pression entre l'intérieur et l'extérieur de la ou chaque pile; de sorte que la circulation de la phase gazeuse entre l'admission dans la chambre et l'évacuation hors de la chambre se fait de l'intérieur vers l'extérieur de la ou chaque pile, ou inversement, la phase gazeuse passant à travers les espaces entre substrats, et diffusant au sein de ceux-ci.

Avantageusement, lorsque la phase gazeuse admise dans la chambre est préchauffée par passage à travers une zone de préchauffage située à la première extrémité de la chambre, la canalisation de la phase gazeuse vers l'intérieur ou l'extérieur de la ou chaque pile est réalisée en sortie de la zone de préchauffage.

Ce procédé apporte une nette amélioration des conditions d'infiltration, en vue d'atteindre le but recherché, en particulier en comparaison avec les procédés connus dans lesquels la phase gazeuse est admise uniformément dans la chambre de réaction, c'est-à-dire, lorsque la chambre contient une ou plusieurs piles de substrats, avec admission de la phase gazeuse à la fois à l'intérieur et à l'extérieur de la ou chaque pile.

Un avantage très important du procédé selon l'invention est que le temps de séjour des gaz dans la chambre de réaction peut être considérablement diminué, sans changer le débit d'admission. En effet, la phase gazeuse est admise uniquement dans le volume représenté soit par l'espace libre formé par le ou les passages centraux de la ou des piles de substrats, soit par l'espace libre autour de la ou des piles de substrats. Ce volume est très sensiblement réduit par rapport au volume total de la chambre de réaction non occupé par le chargement (substrats et outillage de support), c'est-à-dire le volume total desdits espaces libres, de sorte qu'une même quantité de gaz s'écoule beaucoup plus vite. Dans une installation industrielle d'infiltration en phase vapeur de pyrocarbone, le procédé selon l'invention a permis de limiter aisément le temps de séjour à une valeur au plus égale à 1 seconde. La réduction du temps de séjour évite une maturation excessive et une altération de la phase gazeuse qui pourrait avoir pour effet une modification de microstructure du matériau déposé.

En outre, puisque la faculté est offerte de réduire fortement le temps de séjour pour un même débit, on peut, dans la mesure où les résultats obtenus restent acceptables, se contenter d'une diminution moindre du temps de séjour, voire même le conserver inchangé, le débit de phase gazeuse étant alors diminué. La réduction du débit se traduit par une économie de consommation de la phase gazeuse. Elle permet aussi de réduire l'encombrement des moyens de préchauffage, donc d'augmenter le volume utile du four, et d'avoir des moyens de pompage moindres.

De préférence, afin d'optimiser la réduction du temps de séjour et/ou du débit de la phase gazeuse, la canalisation de la phase gazeuse admise est réalisée vers le plus petit des deux volumes constitués par l'intérieur et l'extérieur de la ou des piles de substrats.

Un avantage supplémentaire du procédé réside dans le fait qu'en obligeant la phase gazeuse à circuler de l'intérieur vers l'extérieur de la ou chaque pile de substrats, ou inversement, on assure un renouvellement continu de la phase gazeuse qui baigne les surfaces des substrats et à partir desquelles la diffusion au sein des substrats se produit. Lorsque la phase gazeuse est admise à la fois dans les volumes formés par l'intérieur et l'extérieur de la ou des piles de substrats à une extrémité de ceux-ci, et que ces volumes ne sont pas fermés à leur autre extrémité, il se produit un écoulement préférentiel dans le sens longitudinal. Un renouvellement continu de la phase gazeuse ne peut alors être garanti dans les espaces entre substrats, sauf à prévoir des espaces suffisamment larges. Or, une stagnation de la phase gazeuse dans les espaces entre substrats signifie un temps de séjour important, donc une dégradation de la microstructure du matériau déposé. Et si les substrats sont écartés les uns des autres d'une distance assez grande pour favoriser la circulation de la phase gazeuse entre eux, cela est au détriment du taux de chargement de substrats dans le four d'infiltration.

Avec le procédé selon l'invention, une circulation se produit nécessairement de façon continue dans les espaces entre substrats, de l'intérieur vers l'extérieur de la ou chaque pile, ou inversement. Il est alors possible que les espaces ménagés entre les substrats d'une pile soient de largeur réduite, simplement suffisante pour assurer l'équilibrage des pressions entre l'intérieur et l'extérieur de la pile. Cela permet d'optimiser le taux de remplissage du four par les substrats.

Il peut être souhaitable de maintenir constante la vitesse d'écoulement de la phase gazeuse en direction longitudinale dans le volume intérieur ou extérieur vers lequel elle est canalisée en dépit des pertes de charges causées par les fuites latérales dans les espaces entre substrats et la diffusion au sein de ceux-ci. A cet effet, on peut disposer, dans ce volume, au moins un élément de compensation qui s'étend en direction longitudinale avec une section transversale croissante dans le sens de l'écoulement de la phase gazeuse.

Le procédé selon l'invention est avantageusement mis en oeuvre pour la densification de préformes annulaires de disques de frein. Les préformes peuvent être disposées en une pile ou en plusieurs piles parallèles dans la direction longitudinale de la chambre de réaction. De préférence, la phase gazeuse admise est alors canalisée vers l'intérieur des piles de préformes.

Le procédé selon l'invention peut aussi être mis en oeuvre pour la densification d'autres préformes annulaires ou sensiblement annulaires, en particulier des préformes de divergents de tuyères de propulseur. Les préformes sont alors disposées les unes au-dessus des autres, de préférence en faisant en sorte qu'une préforme soit partiellement engagée dans une autre. Le passage interne de chaque préforme ayant un diamètre relativement grand, la phase gazeuse admise est alors canalisée vers l'extérieur de la ou chaque pile de préformes, qui offre normalement un volume moins important que l'intérieur.

Le procédé selon l'invention peut encore être mis en oeuvre pour la densification de substrats non nécessairement annulaires, c'est-à-dire n'ayant pas nécessairement une forme de révolution avec un passage ou ouverture central. Dans ce cas, l'empilage des substrats est réalisé de façon à former au moins une pile annulaire ou creuse avec un passage intérieur bordé par les substrats empilés.

Des exemples de mise en oeuvre du procédé selon l'invention seront maintenant décrits de façon indicative, mais non limitative.

Il sera fait référence aux dessins annexés sur lesquels :
- la figure 1 illustre schématiquement un chargement d'une chambre de réaction d'une installation d'infiltration chimique en phase vapeur selon un procédé connu ;
- la figure 2 illustre schématiquement un exemple de mise en oeuvre du procédé selon l'invention pour la densification de préformes annulaires de disques de freins ;
- la figure 3 illustre schématiquement un autre exemple de mise en oeuvre du procédé selon l'invention pour la densification de préformes de divergents de tuyères de propulseurs ; et
- la figure 4 illustre schématiquement un autre chargement de substrats permettant la mise en oeuvre d'un procédé selon l'invention.

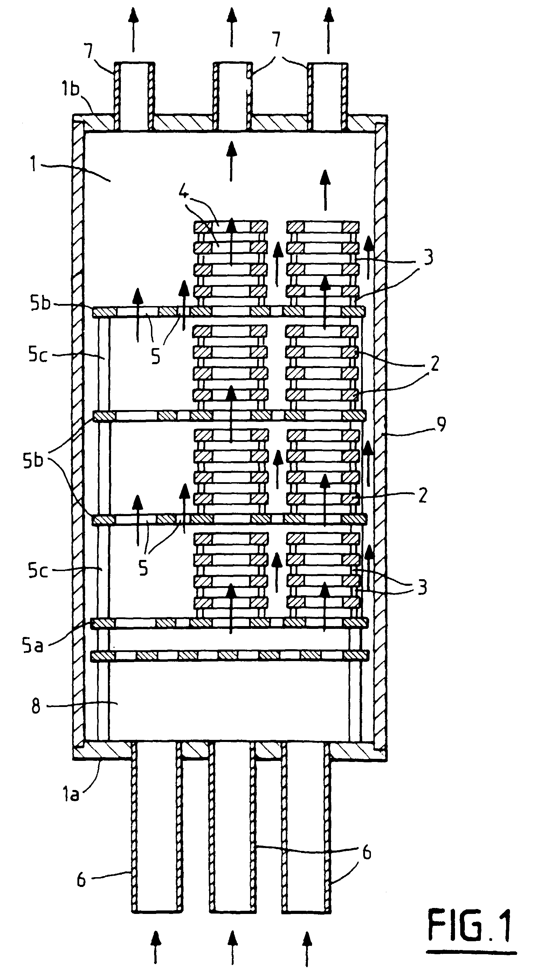

La figure 1 illustre schématiquement une chambre de réaction 1 d'une installation d'infiltration chimique en phase vapeur. La chambre 1 a une forme générale cylindrique d'axe vertical. Des préformes fibreuses annulaires 2, par exemple destinées à la fabrication de disques de freins d'avions en composite carbone-carbone, sont chargées dans la chambre 1 selon une configuration habituelle de l'état de la technique.

Les préformes 1 sont disposées en plusieurs piles qui s'étendent dans la direction longitudinale verticale de la chambre 1 (deux piles seulement sont représentées). Les piles sont supportées par un outillage comprenant des plateaux de chargement inférieur 5a et intermédiaires 5b, munis de perçages 5 pour permettre le passage des gaz, et des entretoises d'espacement 5c entre les plateaux. L'ensemble repose sur le fond 1a de la chambre.

Afin d'assurer la densification des préformes 2, une phase gazeuse contenant un précurseur de carbone, tel que du propane mélangé avec du méthane ou du gaz naturel, est introduite dans la chambre 1. Dans l'exemple illustré, la phase gazeuse est amenée par plusieurs conduites 6 qui débouchent à la partie inférieure de la chambre en des emplacements à peu près régulièrement répartis. Les gaz résiduels sont extraits à la partie supérieure de la chambre par des conduites 7.

Dans la partie inférieure de la chambre, la phase gazeuse traverse une zone de préchauffage 8 contenant des plateaux de préchauffage perforés, avant d'atteindre le plateau de chargement inférieur 5a. Les plateaux de préchauffage étant situés dans la chambre la, ils sont en permanence proches de la température régnant dans celle-ci et permettent un préchauffage efficace de la phase gazeuse.

Le chauffage à l'intérieur de la chambre est produit par un suscepteur en graphite 9 formant un induit couplé électromagnétiquement avec un inducteur (non représenté). Le suscepteur 9 délimite le volume interne de la chambre d'axe vertical avec le fond la traversé par les conduites 6 et un couvercle 1b traversé par les conduites 7. Le fond et le couvercle sont également en graphite, de même que les différents plateaux et entretoises contenus dans la chambre.

La densification des préformes fibreuses 2 est assurée, de façon bien connue en soi, par dépôt au sein de celles-ci de carbone pyrolytique produit par décomposition du précurseur contenu dans la phase gazeuse diffusant à l'intérieur de la porosité inteme accessible des préformes. La phase gazeuse circule dans la chambre 1 entre la zone de préchauffage 8 et les conduits de sortie 7 en passant à l'intérieur et à l'extérieur des piles de substrats 2. Afin de permettre un accès à la phase gazeuse aux faces des préformes 2, celles-ci sont, dans chaque pile, maintenues écartées les unes des autres au moyen d'entretoises 3 qui ménagent des espaces 4 entre les substrats.

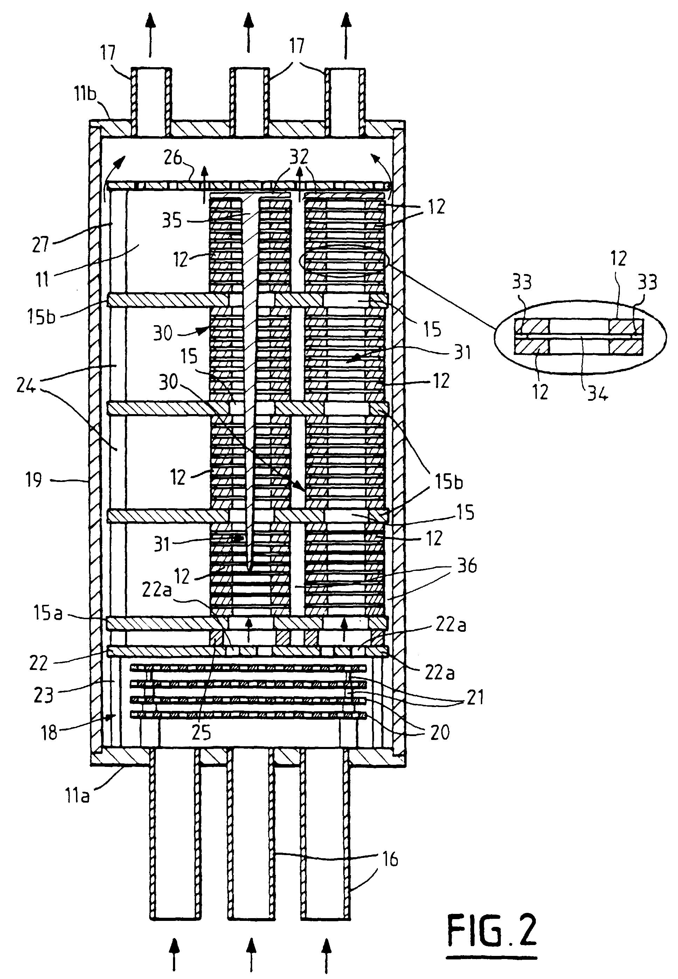

Afin de réaliser la densification de préformes annulaires suivant un procédé conforme à l'invention, le chargement de la chambre de réaction est modifié comme représenté sur la figure 2.

Comme celle illustrée par la figure 1, la chambre de réaction 11 a une forme cylindrique d'axe vertical et est délimitée par un suscepteur en graphite 19, un fond 11a en graphite fermant la chambre à sa partie inférieure et un couvercle en graphite 11b fermant la chambre à sa partie supérieure.

De façon bien connue, l'installation d'infiltration comprend un inducteur (non représenté) qui entoure le suscepteur 19. L'inducteur est couplé au suscepteur 19, formant induit, afin de chauffer la chambre 11. L'alimentation de l'inducteur est commandée de manière à maintenir à la valeur désirée la température régnant dans la chambre 11, mesurée au moyen d'un capteur (non représenté).

Les préformes 12 sont des préformes en fibres de carbone destinées à être densifiées par une matrice de carbone pyrolytique, par exemple des préformes de disques de freins d'avions. Elles sont constituées de strates de fibres de carbone superposées liées entre elles par aiguilletage. Un procédé de réalisation de préformes en fibres de carbone constituées de strates empilées à plat et aiguilletées est décrit notamment dans le document FR-A-2 584 106.

La phase gazeuse contenant un ou plusieurs précurseurs du carbone est introduite dans la chambre 11 par des conduites d'alimentation 16 aboutissant à l'extrémité inférieure de la chambre à travers le fond 11a. La phase gazeuse donnant du carbone pyrolytique est par exemple constituée de propane, précurseur de carbone, et du gaz naturel. Les gaz résiduels sont extraits à la partie supérieure de la chambre au moyen de conduites d'évacuation 17, à travers le couvercle 11b. Les conduites d'évacuation sont reliées à un dispositif de pompage (non représenté) permettant d'établir la pression désirée à l'intérieur de la chambre.

La phase gazeuse pénétrant dans la chambre 11 est préchauffée par passage à travers des plateaux de préchauffage perforés 20, espacés les uns des autres et du fond 11a par des entretoises 21. Les plateaux de préchauffage 20 et entretoises 21 sont en graphite. Par son passage à travers les plateaux 20, la phase gazeuse est portée à une température proche de celle régnant dans la chambre 11.

La phase gazeuse préchauffée passe ensuite à travers un plateau diffuseur 22 qui repose sur le fond 11a par l'intermédiaire de pieds 23. Le plateau 22 présente des passages 22a à intervalles réguliers afin de répartir la phase gazeuse de façon quasi-uniforme dans toute la section de la chambre 11.

Les préformes 12 sont identiques et disposées en piles verticales 30 sur des plateaux supports circulaires 15a, 15b. Ceux-ci présentent des trous 15 et sont maintenus espacés les uns des autres par des entretoises 24. Les plateaux supports 15a, 15b et les entretoises 24 sont par exemple en graphite. Le plateau support inférieur 15a repose sur le plateau diffuseur 22 par l'intermédiaire de cales 25 qui le maintiennent espacé de ce dernier. Un plateau circulaire supérieur 26 perforé peut être disposé au-dessus du chargement afin d'homogénéiser thermiquement le chargement en formant un écran vis-à-vis du rayonnement thermique des préformes situées à la partie supérieure du chargement. Le plateau 26 repose sur le plateau support supérieur par des entretoises 27. Plusieurs piles de préformes sont constituées et réparties à peu près régulièrement sur la surface des plateaux 15a, 15b (deux piles seulement sont montrées sur la figure 2). Chaque pile 30 comporte plusieurs préformes 12 disposées les unes au-dessus des autres suivant un même axe vertical et s'étendant dans l'intervalle entre deux plateaux. Les préformes empilées sur les différents plateaux 15a, 15b sont alignées verticalement avec les trous 15, ces derniers ayant un diamètre égal ou légèrement supérieur au diamètre interne des préformes 12. Ainsi, les piles 30 de préformes alignées verticalement définissent un passage central en forme de cheminée 31 constitué par les ouvertures centrales des préformes annulaires 12 et les trous 15 dans les plateaux. Ces passages 31 sont obturés à leur partie supérieure par des écrans pleins 32.

La phase gazeuse préchauffée issue du plateau diffuseur 22 est canalisée vers le volume constitué par les passages intérieurs 31 des piles 30. A cet effet, les cales 25, disposées entre le plateau diffuseur 22 et le plateau support inférieur 15a, sont des bagues de diamètre interne égal ou légèrement supérieur à celui des trous 15 et sont alignées avec ceux-ci afin que la phase gazeuse soit dirigée exclusivement vers les passages 31. Le plateau diffuseur 22 est muni de perforations 22a uniquement au regard des passages 31.

Des éléments intercalaires 33 de faible épaisseur sont disposés, dans chaque pile, entre les préformes 12 ou, au moins, entre des groupes de préformes empilées. Des éléments intercalaires semblables sont aussi disposés entre les plateaux supports et les premières préformes qui reposent sur ceux-ci, ainsi qu'entre les dernières préformes des piles 30 et les écrans 32. Ces éléments intercalaires 33 ménagent des passages de fuite 34 de la phase gazeuse entre l'intérieur et l'extérieur des préformes, équilibrant la pression entre les passages 31 et le volume interne de la chambre 11, et permettant une diffusion de la phase gazeuse à partir des faces principales planes des préformes 12. Ainsi, la phase gazeuse issue de la zone de préchauffage est canalisée vers les passages internes 31 des piles 30 puis circule de l'intérieur vers l'extérieur de chaque pile 30, dans le volume 36 de la chambre extérieur aux piles 30, d'où elle est évacuée à travers le plateau perforé 26 et les conduits de sortie 17.

Afin de compenser la perte de charge occasionnée par ces fuites latérales auxquelles s'ajoute la diffusion de la phase gazeuse dans les préformes, en vue de maintenir une vitesse d'écoulement de la phase gazeuse sensiblement constante dans les passages 31, la section de passage circulaire de ceux-ci peut être progressivement diminuée dans le sens de circulation de la phase gazeuse, du bas vers le haut. Cette restriction de la section de passage peut être obtenue en insérant dans chaque passage 31 un élément d'outillage central vertical 35 de section croissante dans le sens d'écoulement du flux gazeux. Cet élément d'outillage 35 (un seul est représenté sur la figure 2) en forme de "stalactite" est par exemple fixé sous l'écran 32 situé à la partie supérieure du passage.

Un avantage significatif du procédé conforme à l'invention est la réduction du temps de séjour de la phase gazeuse dans la chambre 11, en comparaison avec une disposition telle que celle de la figure 1, pour un même débit de phase gazeuse admise, et un renouvellement constant de la phase gazeuse baignant les surfaces extérieures des préformes est garanti.

Le temps de séjour a été mesuré dans une chambre de réaction d'un four industriel. Pour un débit d'admission donné, le temps de séjour, mesuré entre les conduits d'admission 16 et le sommet des piles de préformes, est de 0,4 s avec une disposition telle qu'illustrée par la figure 2, tandis qu'il est de 1,8 s avec la disposition de la figure 1. Cette diminution du temps de séjour, due au fait que la phase gazeuse est canalisée vers un volume réduit constitué par les passages intérieurs des piles, garantit la constance de la microstructure du pyrocarbone déposé sur toute la longueur des piles de préformes.

En outre, en réalisant nécessairement une circulation entre l'intérieur et l'extérieur de chaque pile, on obtient un renouvellement continu de la phase gazeuse dans les espaces entre préformes empilées ménagés par les entretoises 34. Ces espaces peuvent donc être de faible largeur, bien inférieure à 5 mm, par exemple compris entre environ 0,1 mm et 5 mm, permettant d'optimiser le taux de remplissage du four. Par contre, dans la disposition de la figure 1, une circulation préférentielle de la phase gazeuse s'établit en direction verticale à l'intérieur et à l'extérieur des piles de préformes. Pour s'assurer qu'une circulation suffisante existe dans les espaces entre préformes empilées, des espaces d'assez grande largeur doivent être ménagés, au détriment du taux de remplissage du four. Faute de quoi il existe un risque d'une stagnation de la phase gazeuse dans les espaces entre préformes et, par conséquent, un risque de dégradation de la microstructure du pyrocarbone déposé par diffusion de cette phase gazeuse.

De plus, puisqu'à débit constant le temps de séjour peut être fortement réduit avec le procédé selon l'invention, à temps de séjour constant, le débit peut être réduit dans une même proportion. Ainsi, si une forte diminution du temps de séjour n'est pas utile pour assurer la constance de la microstructure du pyrocarbone déposé dans toute la chambre, le débit de la phase gazeuse peut être réduit. La consommation de précurseur de carbone est alors diminuée, l'encombrement de la zone de préchauffage peut être réduit, sans affecter la qualité du préchauffage, augmentant ainsi le volume utile de la chambre de réaction, et les besoins de pompage, pour maintenir la pression dans la chambre à la valeur désirée, sont réduits.

Le procédé selon l'invention peut être mis en oeuvre avec des substrats poreux annulaires autres que ceux de la figure 2, plus généralement avec des substrats ayant une forme de révolution avec un passage ou ouverture axial central.

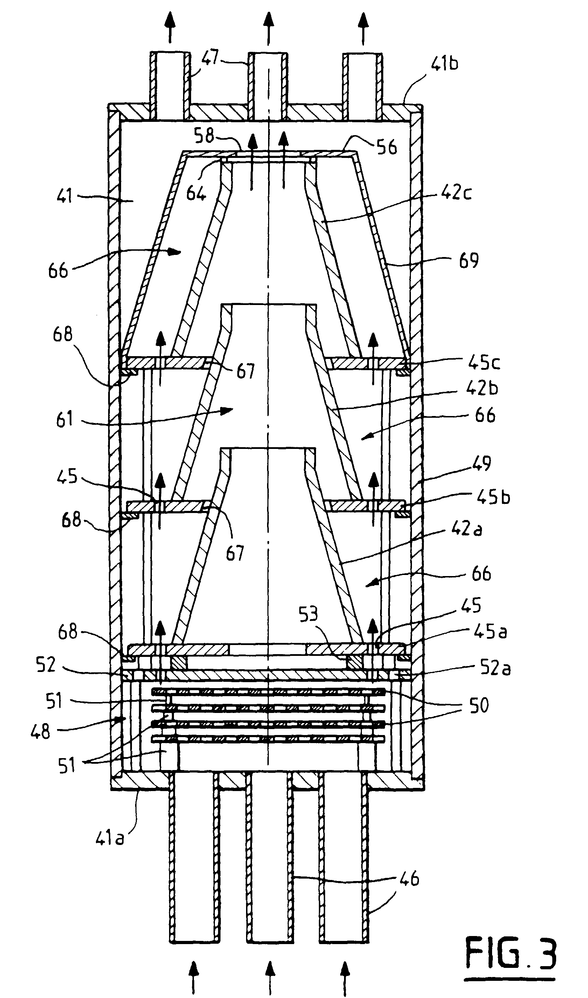

Ainsi, dans la chambre de réaction de l'installation d'infiltration montrée schématiquement sur la figure 3, les substrats poreux à densifier sont des préformes fibreuses de divergents de tuyères pour des propulseurs. Il s'agit par exemple de préformes en fibres de carbone destinées à être densifiées par une matrice de carbone pyrolytique.

Comme celle illustrée par la figure 2, la chambre de réaction 41 a une forme cylindrique d'axe vertical et est délimitée par un suscepteur en graphite 49, un fond 41a en graphite fermant la chambre à la partie inférieure et un couvercle en graphite 41b fermant la chambre à sa partie supérieure. Le suscepteur 49 forme induit couplé à un inducteur (non représenté) entourant la chambre.

La phase gazeuse contenant un ou plusieurs précurseurs du carbone est introduite dans la chambre 41 par des conduites d'alimentation 46 aboutissant à l'extrémité inférieure de la chambre à travers le fond 41a. La phase gazeuse comprend par exemple du propane mélangé à du méthane ou du gaz naturel. Les gaz résiduels sont extraits à la partie supérieure de la chambre au moyen de conduites d'évacuation 47, à travers le couvercle 41b. Les conduites d'évacuation sont reliées à un dispositif de pompage (non représenté) permettant d'établir la pression désirée à l'intérieur de la chambre.

La phase gazeuse pénétrant dans la chambre 41 est préchauffée dans une zone de préchauffage 48 par passage à travers des plateaux de préchauffage perforés 50 espacés les uns des autres et du fond 41a par des entretoises 51. Les plateaux de préchauffage et les entretoises 51 sont par exemple en graphite. Par passage dans la zone de préchauffage 48, à travers les plateaux 50, la phase gazeuse est amenée à une température proche de celle régnant dans la chambre 41. La phase gazeuse préchauffée passe ensuite à travers un plateau diffuseur 52 présentant des trous 52a et reposant sur le fond 41a par l'intermédiaire de pieds.

Les préformes à densifier 42a, 42b, 42c, au nombre de trois dans l'exemple, sont disposées de sorte que leurs axes soient sensiblement confondus avec l'axe vertical de la chambre 41, les divergents s'ouvrant vers le bas. Leur forme tronconique, ou en "coquetier", permet de disposer les préformes de sorte qu'elles soient partiellement engagées les unes dans les autres en formant une pile verticale, les sommets des préformes 42a, 42b étant situés à l'intérieur des préformes 42b, 42c, respectivement.

Les préformes sont supportées au moyen de plateaux horizontaux respectifs, respectivement un plateau inférieur 45a, et deux plateaux intermédiaires annulaires 45b, 45c, maintenus espacés les uns des autres par des entretoises 54. Un plateau supérieur circulaire repose sur la préforme supérieure 42a. Il présente une ouverture centrale 58 alignée avec le passage vertical 51 formé par l'alignement des canaux centraux des préformes.

La phase gazeuse préchauffée issue du plateau diffuseur 52 est canalisée vers un volume 66 situé dans la chambre 41 à l'extérieur des préformes 42a, 42b, 42c. A cet effet, la phase gazeuse préchauffée est canalisée vers des trous calibrés 45 formés dans une zone périphérique du plateau 45a, à l'extérieur de la zone où repose l'extrémité aval de la préforme 42a et traverse aussi des trous calibrés 45 formés dans les zones périphériques des plateaux 45b, 45c, à l'extérieur des zones où reposent les extrémités aval des préformes 42b, 42c. Le plateau inférieur 45a peut être de forme annulaire, afin d'être allégé, auquel cas une bague 53 est disposée entre le plateau diffuseur 52 et le plateau inférieur 45a afin d'empêcher l'accès à la phase gazeuse, vers le passage 61 en sortie de la zone de préchauffage. Le plateau diffuseur 52 n'est alors percé que dans sa zone périphérique.

Les plateaux supports intermédiaires 45b, 45c ont une ouverture centrale 67 dont la paroi peut avoir une forme sensiblement tronconique correspondant à la forme de la surface extérieure des préformes qu'elles entourent et dont la dimension est déterminée, de même que la hauteur des entretoises 54, pour que les plateaux 45b, 45c ménagent avec les surfaces extérieures des préformes 42a, 42b des intervalles de largeur réduite prédéterminée, par exemple d'un ou quelques dixièmes de mm. Un intervalle de largeur semblable est ménagé au moyen d'entretoises 64 entre le sommet de la préforme 42c et le plateau supérieur 56.

Des éléments d'outillage complémentaires peuvent être utilisés tels que des joints annulaires 68 obturant les espaces entre les bords extérieurs des plateaux supports 45a, 45b, 45c et la paroi interne du suscepteur 49 et une paroi tronconique 69 qui s'étend entre la paroi interne du suscepteur 49 et le plateau supérieur 56, autour de la surface extérieure de la préforme 42c afin de délimiter un volume réduit autour de celle-ci. La paroi tronconique 69 peut être fixée sous le plateau supérieur 56.

Les plateaux supports, entretoises et autres éléments d'outillage utilisés dans la chambre 41 sont par exemple en graphite.

Avec la disposition décrite ci-dessus, l'écoulement de la phase gazeuse se fait depuis le volume 66 extérieur à la pile 60 vers le passage intérieur 61 d'où elle est évacuée à travers les conduites 47. Les intervalles entre les préformes 42a, 42b et les plateaux supports intermédiaires 45b,45c, permettent d'équilibrer les pressions entre l'intérieur et l'extérieur de la pile 60 et une circulation continue de la phase gazeuse dans ces intervalles, afin que les surfaces extérieures des préformes 42a, 42b soient baignées par une phase gazeuse constamment renouvelée, jusqu'à leur sommet. L'intervalle entre le sommet de la préforme 42c et le plateau supérieur 56 permet aussi un équilibrage de pression et assure l'évacuation de la phase gazeuse parvenue au sommet du volume 66.

La canalisation de la phase gazeuse issue de la zone de préchauffage vers le volume 66 extérieur aux préformes, plutôt que vers le volume intérieur 61 est préférée pour optimiser le temps de séjour. En effet, contrairement à la configuration de la figure 2, le volume extérieur aux préformes est plus petit que le volume intérieur et une réduction plus grande du temps de séjour est obtenue en dirigeant la phase gazeuse vers le plus petit de ces deux volumes. Les orifices calibrés 45 permettent un certain contrôle de l'écoulement du flux, tandis que la paroi 69 contribue à diminuer le volume 66, tout en ménageant un espace suffisant autour de la préforme 42c.

On retrouve donc ici les avantages évoqués plus haut d'une réduction importante du temps de séjour, notamment quant à la constance de la microstructure du matériau déposé au sein des substrats, sur toute la direction longitudinale de la chambre 41, et à la possibilité offerte de réduire le débit de phase gazeuse admise.

On notera que le nombre de préformes peut être différent de trois, selon leurs dimensions et celle de la chambre d'infiltration, et qu'il n'est pas nécessaire qu'elles soient partiellement engagées les unes dans les autres, l'espace entre préformes voisines pouvant être obturé, à l'exception d'un intervalle de largeur réduite par des éléments d'outillage complétant éventuellement les plateaux supports.

Le procédé selon l'invention peut être mis en oeuvre avec des substrats non nécessairement annulaires. Il suffit alors de disposer les substrats de manière à partager la chambre en un ou plusieurs volumes à l'intérieur desquels la phase gazeuse est admise et un ou plusieurs volumes desquels la phase gazeuse résiduelle est évacuée après être passée entre les substrats ou avoir diffusé à travers ceux-ci. Les substrats sont disposés en une ou plusieurs piles annulaires ou creuses ayant un passage intérieur délimité par les substrats.

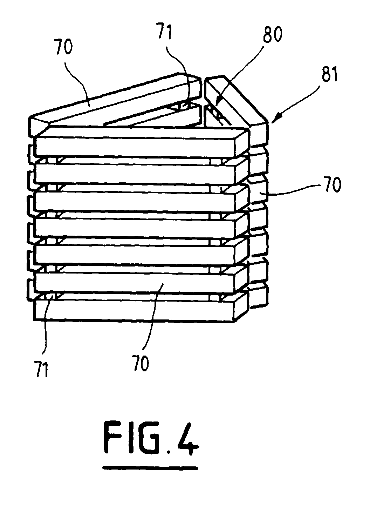

Une telle disposition est illustrée très schématiquement par la figure 4. Les substrats 70 ont la forme de barreaux parallélépipédiques qui sont empilés en couches superposées de manière à former dans chaque couche un polygone fermé ou quasi fermé, par exemple un triangle. Dans une pile, les barreaux 70 délimitent ainsi un passage ou volume intérieur 80 et un volume extérieur 81. Des entretoises 71 sont disposées entre les barreaux 70 superposés afin de les maintenir légèrement espacés les uns des autres.

Les substrats 70 sont chargés dans une chambre en pile(s) verticale(s) par exemple d'une façon similaire à celle illustrée par la figure 2. La différence essentielle tient au remplacement de chaque substrat annulaire par plusieurs substrats disposés pour obtenir une forme polygonale.

Le cas échéant, le partage du volume interne de la chambre de réaction en deux volumes, un dans lequel la phase gazeuse est admise, et l'autre duquel elle est évacuée, peut être réalisé en combinant les substrats et des éléments d'outillage. Il pourra notamment en être ainsi lorsque des substrats de formes et/ou de dimensions différentes sont chargés simultanément.

Bien que l'on ait envisagé dans les exemples qui précèdent la densification de préformes par du carbone pyrolytique, il va de soi que l'invention est applicable à l'infiltration chimique en phase vapeur de matériaux autres que le carbone, en particulier des céramiques, notamment pour la fabrication de pièces en matériau composite à matrice céramique.

En outre, l'alimentation de la chambre en phase gazeuse et l'évacuation des gaz résiduels pourront être réalisées respectivement à la partie supérieure et à la partie inférieure de la chambre de réaction, c'est-à-dire avec un écoulement de la phase gazeuse dans la chambre du haut vers le bas, sans remettre en cause les principes de l'invention.

## Revendications

1. Procédé d'infiltration chimique en phase vapeur pour la densification de substrats poreux par un matériau déposé au sein de ceux-ci, le procédé comprenant : le chargement des substrats à densifier à l'intérieur d'une chambre de réaction d'un four d'infiltration, les substrats étant disposés en au moins une pile annulaire ou creuse qui s'étend dans une direction longitudinale de la chambre et qui délimite un passage intérieur avec des espaces ménagés entre des substrats ; l'admission, au voisinage d'une première extrémité longitudinale de la chambre de réaction, d'une phase gazeuse contenant au moins un précurseur du matériau à déposer; et l'évacuation de gaz résiduels à travers une sortie située au voisinage de l'extrémité longitudinale de la chambre de réaction opposée à la première,
ledit procédé étant caractérisé en ce que la phase gazeuse admise dans la chambre de réaction est canalisée vers l'un des deux volumes constitués par l'intérieur et l'extérieur de la ou des piles de substrats à son extrémité la plus proche de la première extrémité longitudinale de la chambre ; le volume dans lequel la phase gazeuse est canalisée est fermé à son extrémité la plus éloignée de la première extrémité longitudinale de la chambre ; et les espaces ménagés entre des substrats s'ouvrent à l'intérieur et à l'extérieur de la ou chaque pile de manière à équilibrer la pression entre l'intérieur et l'extérieur de la ou chaque pile; de sorte que la circulation de la phase gazeuse entre l'admission dans la chambre et l'évacuation hors de la chambre se fait de l'intérieur vers l'extérieur de la ou chaque pile, ou inversement, la phase gazeuse passant à travers les espaces entre substrats et diffusant au sein de ceux-ci.

2. Procédé selon la revendication 1 dans lequel la phase gazeuse admise dans la chambre est préchauffée par passage à travers une zone de préchauffage située à la première extrémité de la chambre,
caractérisé en ce que la canalisation de la phase gazeuse vers l'intérieur ou l'extérieur de la ou chaque pile est réalisée en sortie de la zone de préchauffage.

3. Procédé selon l'une quelconque des revendications 1 et 2, caractérisé en ce que la canalisation de la phase gazeuse admise est réalisée vers le plus petit des deux volumes constitués par l'intérieur et l'extérieur de la ou des piles de substrats.

4. Procédé selon l'une quelconque des revendications 1 à 3, caractérisé en ce que l'on dispose, à l'intérieur de la ou chaque pile un élément de compensation ayant une section croissante dans le sens de l'écoulement de la phase gazeuse afin de compenser les fuites latérales à travers les substrats et entre ceux-ci par une réduction de la section de passage à l'intérieur de la pile de manière à maintenir une vitesse d'écoulement de la phase gazeuse sensiblement constante en direction longitudinale à l'intérieur de la pile.

5. Procédé selon l'une quelconque des revendications 1 à 4 pour la densification de substrats ayant sensiblement une forme de révolution avec une ouverture centrale, caractérisé en ce que les substrats sont disposés en au moins une pile qui délimite un volume intérieur formé par les ouvertures centrales des substrats.

6. Procédé selon la revendication 5 pour la densification de préformes annulaires pour des disques de frein, caractérisé en ce que l'on ménage entre les préformes de la ou chaque pile des espaces de moins de 5 mm de largeur.

7. Procédé selon l'une quelconque des revendications 5 et 6, pour la densification de préformes annulaires pour de disques de frein, caractérisé en ce que l'on charge les préformes dans la chambre en plusieurs piles parallèles.

8. Procédé selon la revendication 7, caractérisé en ce que la phase gazeuse admise dans la chambre est canalisée vers le volume intérieur des piles de préformes.

9. Procédé selon la revendication 5 pour la densification de préformes de divergents de tuyères de propulseurs, caractérisé en ce que la phase gazeuse admise dans la chambre est canalisée vers le volume situé à l'extérieur des préformes.

10. Procédé selon l'une quelconque des revendications 5 et 9, pour la densification de préformes de divergents de tuyères de propulseurs, caractérisé en ce que les préformes sont disposées les unes au-dessus des autres en faisant en sorte qu'une préforme soit partiellement engagée à l'intérieur d'une autre.

## Patentansprüche

1. Verfahren zur chemischen Infiltration in der Dampfphase für die Verdichtung von porösen Substraten durch ein innerhalb dieser abgelagertes Material, wobei das Verfahren aufweist: die Einbringung der zu verdichtenden Substrate in das Innere einer Reaktionskammer eines Infiltrationsofens, wobei die Substrate in wenigstens einem ringförmigen oder hohlen Stapel angeordnet werden, welcher sich in einer Längsrichtung der Kammer erstreckt und welcher eine innere Passage mit zwischen Substraten ausgesparten Räumen begrenzt; die in Nachbarschaft eines ersten Längsendes der Reaktionskammer vorgesehene Zuführung einer Gasphase, welche wenigstens einen Vorläufer des abzulagernden Materials enthält; und der Abzug von Restgasen durch einen Ausgang, der in Nachbarschaft des dem ersten Längsende entgegengesetzten Längsendes der Reaktionskammer angeordnet ist, wobei das vorgenannte Verfahren dadurch gekennzeichnet ist, daß die in die Reaktionskammer zugeführte Gasphase in das eine von zwei Volumina geleitet wird, welche durch das Innere und das Äußere des Substratstapels oder der Substratstapel an dem dem ersten Längsende der Kammer am nächsten befindlichen Ende des Volumens gebildet sind; daß das Volumen, in welches die Gasphase geleitet wird, an seinem von dem ersten Längsende der Kammer am entferntesten befindlichen Ende geschlossen wird; und daß die zwischen Substraten ausgesparten Räume sich zu dem Inneren und zu dem Außeren des oder jedes Stapels in der Weise öffnen, um den Druck zwischen dem Inneren und dem Äußeren des oder jedes Stapels auszugleichen; derart, daß der Umlauf der Gasphase zwischen der Zuführung in die Kammer und dem Abzug aus der Kammer von dem Inneren zu dem Äußeren des oder jedes Stapels oder umgekehrt erfolgt, wobei die Gasphase quer durch die Räume zwischen Substraten strömt und sich innerhalb dieser Räume ausbreitet.

2. Verfahren nach Anspruch 1, bei welchem die in die Kammer zugeführte Gasphase mittels Passage durch eine Vorerwärmungszone vorerwärmt wird, die an dem ersten Ende der Kammer angeordnet ist,
dadurch gekennzeichnet, daß das Leiten der Gasphase zu dem Inneren oder dem Äußeren des oder jedes Stapels am Ausgang der Vorerwärmungszone erfolgt.

3. Verfahren nach einem der Ansprüche 1 und 2, dadurch gekennzeichnet, daß das Leiten der zugeführten Gasphase zu dem kleinsten der zwei Volumen erfolgt, welche durch das Innere und das Äußere des Substratstapels oder der Substratstapel gebildet sind.

4. Verfahren nach einem der Ansprüche 1 bis 3, dadurch gekennzeichnet, daß man im Inneren des oder jedes Stapels ein Kompensationselement mit einem in dem Sinne der Strömung der Gasphase zunehmenden Querschnitt anordnet, um die seitlichen Lecks durch die Substrate und zwischen diesen durch eine Verminderung des Querschnitts der Passage in dem Inneren des Stapels in der Weise zu kompensieren, daß eine in Längsrichtung in dem Inneren des Stapels im wesentlichen konstante Strömungsgeschwindigkeit der Gasphase aufrechterhalten wird.

5. Verfahren nach einem der Ansprüche 1 bis 4 für die Verdichtung von Substraten, welche im wesentlichen eine Rotationsgestalt mit einer zentralen Öffnung aufweisen, dadurch gekennzeichnet, daß die Substrate in wenigstens einem Stapel angeordnet werden, welcher ein inneres Volumen begrenzt, das durch die zentralen Öffnungen der Substrate gebildet ist.

6. Verfahren nach Anspruch 5 für die Verdichtung von ringförmigen Vorformlingen für Bremsscheiben, dadurch gekennzeichnet, daß man zwischen den Vorformlingen des oder jedes Stapels Räume mit jeweils wenigstens 5 mm Breite ausspart.

7. Verfahren nach einem der Ansprüche 5 und 6 für die Verdichtung von ringförmigen Vorformlingen für Bremsscheiben, dadurch gekennzeichnet, daß man die Vorformlinge in die Kammer in mehreren parallelen Stapeln einbringt.

8. Verfahren nach Anspruch 7, dadurch gekennzeichnet, daß die in die Kammer zugeführte Gasphase zu dem inneren Volumen der Stapel der Vorformlinge geleitet wird.

9. Verfahren nach Anspruch 5 für die Verdichtung von Vorformlingen für Divergenzbereiche von Triebwerksdüsen, dadurch gekennzeichnet, daß die in die Kammer zugeführte Gasphase zu dem Volumen geleitet wird, das sich an dem Äußeren der Vorformlinge befindet.

10. Verfahren nach einem der Ansprüche 5 und 9 für die Verdichtung von Vorformlingen für Triebwerkexpansionsdüsen, dadurch gekennzeichnet, daß die Vorformlinge derart einer über dem anderen angeordnet werden, daß ein Vorformling teilweise in dem Inneren eines anderen eingelassen ist.

## Claims

1. A chemical vapor infiltration method for densifying porous substrates by depositing material within the substrates, the method comprising: loading substrates to be densified into a reaction chamber of an infiltration oven, the substrates being disposed in at least one annular or hollow stack which extends in a longitudinal direction of the chamber and which defines an interior passage with spaces being formed between the substrates; admitting a gas containing at least a precursor of the material to be deposited in the vicinity of a first longitudinal end of the reaction chamber; and exhausting the residual gas via an outlet situated in the vicinity of the longitudinal end of the reaction chamber opposite from the first longitudinal end;
said method being characterized in that the gas admitted into the reaction chamber is channeled towards one of the two volumes constituted by the inside and the outside of the stack(s) of substrates at the end thereof closer to the first longitudinal end of the chamber; the volume into which the gas is channeled is closed at its end further from the first longitudinal end of the chamber; and the spaces formed between the substrates open into the inside and the outside of the, or each, stack in order to balance the pressure between the inside and the outside of the, or each, stack; such that, between admission into the chamber and exhaust from the chamber, the gas flows from the inside towards the outside of the, or each, stack, or vice versa, with the gas passing through the spaces between the substrates and diffusing into them.

2. A method according to claim 1, in which the gas admitted into the chamber is preheated by passing through a preheating zone situated at the first end of the chamber,
characterized in that the channeling of the gas towards the inside or the outside of the, or each, stack is performed at the outlet from the preheating zone.

3. A method according to claim 1 or 2, characterized in that the channelling of the admitted gas is performed towards the smaller of the two volumes constituted by the inside and the outside of the stack(s) of substrates.

4. A method according to any one of claims 1 to 3, characterized in that a compensation element is disposed inside the, or each, stack, the section of the compensation element increasing in the flow direction of the gas so as to compensate for lateral leaks through the substrates and between them by reducing the flow section inside the stack in such a manner as to maintain a substantially constant flow speed for the gas in the longitudinal direction inside the stack.

5. A method according to any one of claims 1 to 4, for densifying substrates that are substantially in the form of a body of revolution with a central opening, characterized in that the substrates are disposed in at least one stack which defines an interior volume formed by the central openings of the substrates.

6. A method according to claim 5, for densifying annular preforms for brake disks, characterized in that the spaces between the preforms in the, or each, stack are caused to be less than 5 mm wide.

7. A method according to claim 5 or 6, for densifying annular preforms for brake disks, characterized in that the preforms are loaded into the chamber in a plurality of parallel stacks.

8. A method according to claim 7, characterized in that the gas admitted into the chamber is channelled towards the interior volume of the stacks of preforms.

9. A method according to claim 5, for densifying preforms for the diverging parts of thruster nozzles, characterized in that the gas admitted into the chamber is channelled towards the volume situated outside the preforms.

10. A method according to any one of claims 5 and 9, for densifying preforms for the diverging parts of thruster nozzles, characterized in that the preforms are disposed one above the other in such a manner that a preform is partially engaged inside another.
